# EUROPEAN PATENT APPLICATION

(11) **EP 3 780 122 A1**
(43) Date of publication of application: **17.02.2021**
(21) Application number: 19774613.4
(22) Date of filing: 13.03.2019
(51) Int. Cl.: H01L 31/0463, H01L 31/18

(54) **METHOD FOR MANUFACTURING SOLAR CELL, AND SOLAR CELL**

(30) Priority: 27.03.2018 JP 2018060126
(71) Applicant: Sekisui Chemical Co., Ltd., Osaka-shi, Osaka 530-0047 (JP)
(72) Inventor: AITA, Tetsuya, Mishima-gun, Osaka 618-0021 (JP); ASANO, Motohiko, Mishima-gun, Osaka 618-0021 (JP); HAYAKAWA, Akinobu, Mishima-gun, Osaka 618-0021 (JP); UNO, Tomohito, Mishima-gun, Osaka 618-0021 (JP); KUREBAYASHI, Tetsuya, Mishima-gun, Osaka 618-0021 (JP); KUNUGI, Shunsuke, Mishima-gun, Osaka 618-0021 (JP); MORITA, Takeharu, Mishima-gun, Osaka 618-0021 (JP)
(74) Representative: Cabinet Beau de Loménie
(86) International application number: PCT/JP2019/010268
(87) International publication number: WO 2019/188288

(57) **Abstract**

The present invention aims to provide a method for producing a solar cell in which a continuous long scribed line is provided along the machine direction of a substrate so that failures due to breakage of the scribed line are reduced. Provided is a method for producing a solar cell, the method being for producing plural monolithic solar cells in batches by a roll-to-roll method, the method including: step (1) of forming a lower electrode on a long substrate and scribing the lower electrode to provide a scribed line along the machine direction of the substrate; step (2) of forming a photoelectric conversion layer on the lower electrode provided with the scribed line and scribing the photoelectric conversion layer to provide a scribed line along the machine direction of the substrate; step (3) of forming an upper electrode on the photoelectric conversion layer provided with the scribed line and scribing the upper electrode to provide a scribed line along the machine direction of the substrate, the scribing in at least one of the steps (1) to (3) including: step (a) of providing a first scribed line; step (b) of providing a second scribed line; and step (c) of providing a third scribed line.

## Description

### TECHNICAL FIELD

The present invention relates to a method for producing a solar cell, the method being for producing plural monolithic solar cells in batches by a roll-to-roll method, in which a continuous long scribed line is provided along the machine direction of a substrate so that failures due to breakage of the scribed line are reduced. The present invention also relates to a solar cell obtained by the method for producing a solar cell.

### BACKGROUND ART

Solar cells in which a photoelectric conversion layer is arranged between opposing electrodes have been developed. For example, attention has been paid to perovskite solar cells having a photoelectric conversion layer formed from an organic-inorganic perovskite compound with a perovskite structure that includes lead, tin, or the like as a central metal (see Patent Literature 1 and Non-Patent Literature 1, for example).

Recently, flexible solar cells including, as a substrate, a polyimide, polyester-based heat-resistant polymer material or metal foil have attracted attention. Flexible solar cells have advantages such as easy transport and working owing to thinning and weight reduction thereof, and shock resistance. For example, Patent Literature 2 discloses a substrate for a semiconductor device including a sheet-shaped aluminum substrate and an organic thin-film solar cell including the substrate for a semiconductor device.

### CITATION LIST

### - Patent Literature

Patent Literature 1: JP 2014-72327 A
Patent Literature 2: JP 2013-253317 A

### - Non-Patent Literature

Non-Patent Literature 1: M. M. Lee, et al, Science, 2012, 338, 643

### SUMMARY OF INVENTION

### - Technical Problem

In production of flexible solar cells, a roll-to-roll (R to R) method has recently been used. In the R to R method, while a long substrate in a roll is fed out and shifted, respective layers such as a lower electrode, a photoelectric conversion layer, and an upper electrode are sequentially stacked thereon. During this process, scribing is performed on each layer, so that a so-called monolithic solar cell is produced in which the layers such as a lower electrode, a photoelectric conversion layer, and an upper electrode each have plural grooves and adjacent lower electrode and upper electrode are connected to each other. The R to R method in which plural solar cells are produced in batches and then divided into individual solar cells is excellent in terms of mass production and production efficiency.

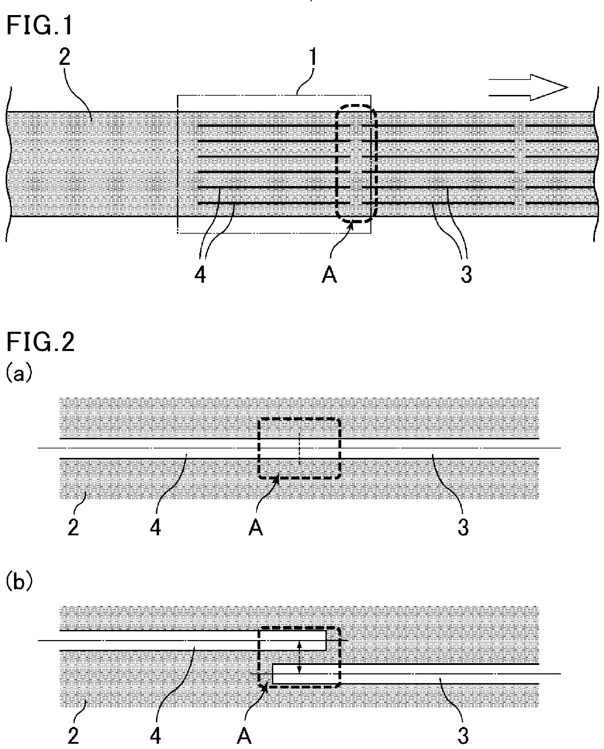

In the scribing, scribed lines are provided along the machine direction or the width direction of the substrate. Fig. 1 is a schematic view of an exemplary method for providing scribed lines along the machine direction of a substrate by a roll-to-roll method. In the case where scribed lines are provided along the machine direction of a substrate, as illustrated in Fig. 1, a laminate 2 including a substrate and respective layers formed on the substrate is set on a stage 1 of a scribing device and scribing is performed thereon to provide first scribed lines 3. Next, the laminate 2 is shifted in the direction of an arrow in Fig. 1 by the length of the stage 1 of the scribing device (for example, about 500 mm) by step feeding or the like, and scribing is performed again to provide second scribed lines 4. Scribed lines can be provided along the machine direction of the substrate by repetition of this process. To provide continuous long scribed lines without breakage, the end points of the first scribed lines 3 and the start points of the second scribed lines 4 need to be connected to each other in a connecting portion A between the first scribed lines 3 and the second scribed lines 4.

The scribed lines are connected as follows: The scribing device detects the end points of the first scribed lines with its alignment system before starting scribing to provide the second scribed lines, and then starts scribing to provide the second scribed lines in such a manner that the start points of the second scribed lines overlap the end points of the first scribed lines. In order to widen a power generation area and narrow a non-power generation area of solar cells, the width of scribed lines has recently been desired to be narrowed to, for example, 40 µm or less. It becomes therefore harder to connect the scribed lines accurately with the operating accuracy (for example, operating accuracy of about ±50 µm) of conventional alignment systems. Spending more time for alignment may allow accurate connection of the scribed lines but is not preferred in terms of the production efficiency. Fig. 2 shows schematic views illustrating exemplary connecting portions of scribed lines when the scribed lines are provided along the machine direction of the substrate by a roll-to-roll method. Fig. 2(a) shows a case where the end point of the first scribed line 3 and the start point of the second scribed line 4 are connected to each other on the laminate 2. Fig. 2(b) shows a case where the end point of the first scribed line 3 and the start point of the second scribed line 4 are not connected to each other on the laminate 2 and the scribed lines are broken.

The present invention aims to provide a method for producing a solar cell, the method being for producing plural monolithic solar cells in batches by a roll-to-roll method, in which a continuous long scribed line is provided along the machine direction of a substrate so that failures due to breakage of the scribed line are reduced. The present invention also aims to provide a solar cell obtained by the method for producing a solar cell.

### - Solution to problem

The present invention relates to a method for producing a solar cell, the method being for producing plural monolithic solar cells in batches by a roll-to-roll method, the method including: step (1) of forming a lower electrode on a long substrate and scribing the lower electrode to provide a scribed line along the machine direction of the substrate; step (2) of forming a photoelectric conversion layer on the lower electrode provided with the scribed line and scribing the photoelectric conversion layer to provide a scribed line along the machine direction of the substrate; and step (3) of forming an upper electrode on the photoelectric conversion layer provided with the scribed line and scribing the upper electrode to provide a scribed line along the machine direction of the substrate, the scribing in at least one of the steps (1) to (3) including step (a) of placing a laminate including the lower electrode, the photoelectric conversion layer, or the upper electrode on a stage of a scribing device and scribing the lower electrode, the photoelectric conversion layer, or the upper electrode to provide a first scribed line; step (b) of shifting the laminate by the length of the stage of the scribing device and scribing the lower electrode, the photoelectric conversion layer, or the upper electrode to provide a second scribed line; and step (c) of scribing the lower electrode, the photoelectric conversion layer, or the upper electrode in such a manner that the end point of the first scribed line and the start point of the second scribed line are connected to each other to provide a third scribed line.

The present invention is specifically described in the following.

The present inventors found out that specific scribing in a method for producing plural monolithic solar cells in batches by a roll-to-roll method can surely connect scribed lines even in a case where the widths of the scribed lines are narrower than conventional one, for example, 40 µm or less. The present inventors found out that ensured connection of scribed lines mentioned above can provide a continuous long scribed line along the machine direction of the substrate, and failures due to breakage of the scribed line can be reduced. Thus, the present invention was completed.

The method for producing a solar cell of the present invention is a method for producing plural monolithic solar cells in batches by a roll-to-roll method.

The monolithic type refers to a structure including a laminate with respective layers such as a lower electrode, a photoelectric conversion layer, and an upper electrode, in which the respective layers such as a lower electrode, a photoelectric conversion layer, and an upper electrode individually have plural grooves and adjacent lower electrode and upper electrode are connected to each other. In other words, the monolithic type refers to a structure in which plural unit cells separated by plural grooves are connected in tandem.

In the method for producing a solar cell of the present invention, a step (1) is first conducted in which a lower electrode is formed on a long substrate and the lower electrode is scribed so that a scribed line along the machine direction of the substrate is provided.

The substrate may be any one, and examples thereof include resin films formed from a polyimide- or polyester-based heat-resistant polymer, metal foil, and thin plate glass. In particular, metal foil is preferred. The use of metal foil can reduce the cost and enables high-temperature treatment in comparison with the case of using a heat-resistant polymer. In other words, even when thermal annealing (heating treatment) at a temperature of not lower than 80°C is performed for the purpose of imparting light resistance (resistance to photo-deterioration) in formation of a photoelectric conversion layer containing an organic-inorganic perovskite compound, occurrence of distortion can be minimized and high photoelectric conversion efficiency can be achieved.

The metal foil may be any one, and examples thereof include a metal foil formed of a metal such as aluminum, titanium, copper, or gold, and a metal foil formed of an alloy such as stainless steel (SUS). These may be used alone or in combination of two or more. In particular, aluminum foil is preferred. The use of aluminum foil can reduce the cost and can improve the workability owing to its flexibility in comparison with the case of using other metal foil.

The substrate may further include an insulating layer formed on the metal foil. In other words, the substrate may be one including a metal foil and an insulating layer formed on the metal foil.

The insulating layer may be any one, and examples thereof include inorganic insulating layers formed from aluminum oxide, silicon oxide, zinc oxide, or the like, and organic insulating layers formed from epoxy resin, polyimide, or the like. In particular, when the metal foil is an aluminum foil, the insulating layer is preferably an aluminum oxide film.

The use of the aluminum oxide film as the insulating layer can reduce deterioration of the photoelectric conversion layer (especially, a photoelectric conversion layer containing an organic-inorganic perovskite compound) due to permeation of moisture in the air through the insulating layer in comparison with the case of an organic insulating layer. The use of the aluminum oxide film as the insulating layer can also reduce a phenomenon in which the photoelectric conversion layer containing an organic-inorganic perovskite compound is discolored over time as a result of contact with the aluminum foil and corrosion occurs.

For other common solar cells, no report has been made on discoloration of a photoelectric conversion layer due to a reaction with aluminum. The above phenomenon of corrosion occurrence is a problem characteristic of a perovskite solar cell in which the photoelectric conversion layer contains an organic-inorganic perovskite compound. This problem is found by the present inventors.

The aluminum oxide film may have any thickness. The lower limit of the thickness is preferably 0.1 µm and the upper limit thereof is preferably 20 µm. The lower limit is more preferably 0.5 µm and the upper limit is more preferably 10 µm. When the thickness of the aluminum oxide film is 0.5 µm or greater, the aluminum oxide film can sufficiently cover a surface of the aluminum foil, leading to stable insulation between the aluminum foil and the lower electrode. When the thickness of the aluminum oxide film is 10 µm or smaller, a crack is less likely to be generated in the aluminum oxide film even when the substrate is bent. Further, in the heating treatment in formation of a photoelectric conversion layer containing an organic-inorganic perovskite compound, generation of a crack can be reduced in the aluminum oxide film and/or the layer formed thereon due to difference in coefficient of thermal expansion from the aluminum foil.

The thickness of the aluminum oxide film can be measured by, for example, observing a cross section of the substrate using an electron microscope (e.g., S-4800 available from HITACHI Ltd.) and analyzing the contrast of the picture taken.

The proportion of the thickness of the aluminum oxide film to the thickness of the substrate, which is taken as 100%, may be any value. The lower limit of the proportion is preferably 0.1% and the upper limit thereof is preferably 15%. When the proportion is 0.1% or higher, the aluminum oxide film has higher hardness, which allows favorable scribing while suppressing detachment of the aluminum oxide film upon scribing of the lower electrode, leading to reduction of occurrence of insulation failures or conduction failures. When the proportion is 15% or lower, generation of a crack can be reduced in the aluminum oxide film and/or the layer formed thereon due to difference in coefficient of thermal expansion from the aluminum foil in the heating treatment in formation of a photoelectric conversion layer containing an organic-inorganic perovskite compound. As a result, increase in the resistance value of the solar cell or occurrence of corrosion in the photoelectric conversion layer containing an organic-inorganic perovskite compound due to exposure of the aluminum foil can be reduced. The lower limit of the proportion is more preferably 0.5% and the upper limit thereof is more preferably 5%.

The aluminum oxide film may be formed by any method. Examples of the method include a method of anodizing the aluminum foil, a method of applying an alkoxide of aluminum on a surface of the aluminum foil, and a method of forming a natural oxide film on a surface of the aluminum foil by heat treatment. In particular, the method of anodizing the aluminum foil is preferred because this method can uniformly oxidize the whole surface of the aluminum foil and thus is suitable for mass production. In other words, the aluminum oxide film is preferably an anodic oxide film.

In the case of anodizing the aluminum foil, the thickness of the aluminum oxide film can be adjusted by changing the treatment concentration, treatment temperature, current density, treatment duration, and the like in the anodizing. The treatment duration may be any value. From the viewpoint of easy production of the substrate, the lower limit thereof is preferably 5 minutes and the upper limit thereof is preferably 120 minutes, the upper limit is more preferably 60 minutes.

The substrate may have any thickness. The lower limit of the thickness is preferably 5 µm and the upper limit thereof is preferably 500 µm. When the thickness of the substrate is 5 µm or greater, the resulting solar cell can have sufficient mechanical strength and excellent handleability. When the thickness of the substrate is 500 µm or smaller, the resulting solar cell can have excellent flexibility. The lower limit of the thickness of the substrate is more preferably 10 µm and the upper limit thereof is more preferably 100 µm.

When the substrate includes the metal foil and an insulating layer formed on the metal foil, the thickness of the substrate means the thickness of the whole substrate including the metal foil and the insulating layer.

The substrate may have any length as long as it is considered to be long and is a common length used in R to R production methods of solar cells. Usually, the length is about 2,000 m at the maximum.

The lower electrode may be either a cathode or an anode. Examples of the materials of the lower electrode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, and metals such as gold. The examples also include transparent conductive materials such as CuI, indium tin oxide (ITO), SnO₂, aluminum zinc oxide (AZO), indium zinc oxide (IZO), and gallium zinc oxide (GZO), and transparent conductive polymers. These materials may be used alone or in combination of two or more.

The lower electrode may be a metal electrode. Examples of a metal constituting the metal electrode include, in addition to aluminum or the like described above, titanium, molybdenum, silver, nickel, tantalum, gold, SUS, and copper. These metals may be used alone or in combination of two or more.

The lower electrode may be formed by any method. For example, it may be formed by continuously performing vapor deposition, sputtering, ion plating, or the like using a R to R device.

In the step (1), the lower electrode formed is scribed so that scribed lines along the machine direction of the substrate are provided. The details of the scribing are described later.

The method for producing a solar cell of the present invention subsequently includes a step (2) of forming a photoelectric conversion layer on the lower electrode provided with the scribed line and scribing the photoelectric conversion layer so that a scribed line along the machine direction of the substrate is provided.

The photoelectric conversion layer preferably contains an organic-inorganic perovskite compound represented by the formula: R-M-X₃, wherein R represents an organic molecule; M represents a metal atom; and X represents a halogen atom or a chalcogen atom. The use of the organic-inorganic perovskite compound in the photoelectric conversion layer can improve the photoelectric conversion efficiency of the solar cell.

The term "layer" as used herein means not only a layer having a clear boundary, but also a layer having a concentration gradient in which contained elements are gradually changed. The elemental analysis of the layer can be performed, for example, by FE-TEM/EDS analysis of a cross section of the solar cell to confirm the element distribution of a particular element. Also, the term "layer" as used herein means not only a flat thin-film layer, but also a layer capable of forming an intricate structure together with other layer(s).

R is an organic molecule and is preferably represented by C₁NₘHₙ (l, m, and n each represent a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, imidazoline, carbazole, methyl carboxy amine, ethyl carboxy amine, propyl carboxy amine, butyl carboxy amine, pentyl carboxy amine, hexyl carboxy amine, formamidinium, guanidine, aniline, pyridine, and ions thereof, and phenethyl ammonium. An exemplary ion is methyl ammonium (CH₃NH₃). In particular, methylamine, ethylamine, propylamine, propyl carboxy amine, butyl carboxy amine, pentyl carboxy amine, formamidinium, guanidine, and ions thereof are preferred, and methylamine, ethylamine, pentyl carboxy amine, formamidinium, guanidine, and ions thereof are more preferred. In particular, methylamine, formamidinium, and ions thereof are still more preferred because they can lead to high photoelectric conversion efficiency.

M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. From the viewpoint of electron orbital overlap, lead or tin is preferred. These metal atoms may be used alone or in combination of two or more.

X represents a halogen atom or a chalcogen atom. Examples thereof include chlorine, bromine, iodine, sulfur, and selenium. These halogen atoms and chalcogen atoms may be used alone or in combination of two or more. In particular, a halogen atom is preferred because the organic-inorganic perovskite compound containing halogen in the structure is soluble in an organic solvent and can be used in an inexpensive printing method or the like. In addition, iodine is more preferred because the organic-inorganic perovskite compound can have a narrower energy band gap.

The organic-inorganic perovskite compound preferably has a cubic crystal structure where the metal atom M is placed at the body center, the organic molecule R is placed at each vertex, and the halogen or chalcogen atom X is placed at each face center.

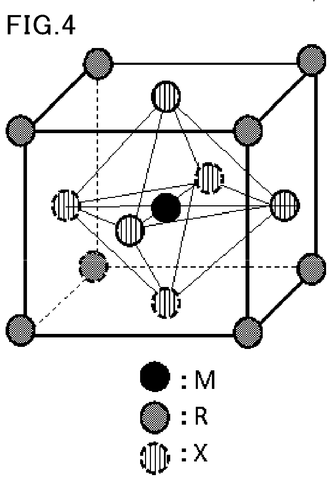

Fig. 4 is a schematic view of an exemplary crystal structure of the organic-inorganic perovskite compound having a cubic crystal structure where the metal atom M is placed at the body center, the organic molecule R is placed at each vertex, and the halogen or chalcogen atom X is placed at each face center. Although the details are not clear, it is presumed that this structure allows the octahedron in the crystal lattice to change its orientation easily, which enhances the mobility of electrons in the organic-inorganic perovskite compound, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution.

When the organic-inorganic perovskite compound is a crystalline semiconductor, the mobility of electrons in the organic-inorganic perovskite compound is enhanced, improving the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by a fitting technique, determining the respective intensity integrals, and calculating the proportion of the crystalline portion to the whole.

The lower limit of the degree of crystallinity of the organic-inorganic perovskite compound is preferably 30%. When the degree of crystallinity is 30% or higher, the mobility of electrons in the organic-inorganic perovskite compound is enhanced, improving the photoelectric conversion efficiency of the solar cell. The lower limit of the degree of crystallinity is more preferably 50%, still more preferably 70%.

Examples of the method for increasing the degree of crystallinity of the organic-inorganic perovskite compound include thermal annealing (heating treatment), irradiation with strong-intensity light, such as laser, and plasma irradiation.

The crystallite diameter may also be evaluated as another index of crystallization. The crystallite diameter can be calculated from the half width of a crystalline substance-derived scattering peak, which is detected by X-ray scattering intensity distribution measurement, by the Halder-Wagner method.

The lower limit of the crystallite diameter of the organic-inorganic perovskite compound is preferably 5 nm. When the crystallite diameter is 5 nm or greater, the mobility of electrons in the organic-inorganic perovskite compound is enhanced, improving the photoelectric conversion efficiency of the solar cell. The lower limit of the crystallite diameter is more preferably 10 nm, still more preferably 20 nm.

The photoelectric conversion layer may further contain an organic semiconductor or an inorganic semiconductor, in addition to the organic-inorganic perovskite compound, as long as the effects of the present invention are not impaired.

Examples of the organic semiconductor include compounds having a thiophene skeleton, such as poly(3-alkylthiophene). The examples also include conductive polymers having a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, a porphyrin skeleton such as a benzoporphyrin skeleton, a spirobifluorene skeleton, or the like; and carbon-containing materials such as carbon nanotube, graphene, and fullerene, each of which may be surface-modified.

Examples of the inorganic semiconductor include titanium oxide, zinc oxide, indium oxide, tin oxide, gallium oxide, tin sulfide, indium sulfide, zinc sulfide, CuSCN, CU₂O, CuI, MoO₃, V₂O₅, WO₃, MoS₂, MoSe₂, and Cu₂S.

The photoelectric conversion layer containing the organic-inorganic perovskite compound and the organic semiconductor or inorganic semiconductor may be a laminate in which a thin-film organic semiconductor or inorganic semiconductor part and a thin-film organic-inorganic perovskite compound part are stacked, or may be a composite film in which an organic semiconductor or inorganic semiconductor part and an organic-inorganic perovskite compound part are combined. The laminate is preferred from the viewpoint of a simple production process. The composite film is preferred from the viewpoint of improvement in charge separation efficiency in the organic semiconductor or the inorganic semiconductor.

The lower limit of the thickness of the thin-film organic-inorganic perovskite compound part is preferably 5 nm and the upper limit thereof is preferably 5,000 nm. When the thickness is 5 nm or greater, the thin-film organic-inorganic perovskite compound part can sufficiently absorb light, enhancing the photoelectric conversion efficiency. When the thickness is 5,000 nm or smaller, formation of a region which fails to achieve charge separation can be reduced, improving the photoelectric conversion efficiency. The lower limit of the thickness is more preferably 10 nm and the upper limit thereof is more preferably 1,000 nm. The lower limit of the thickness is still more preferably 20 nm and the upper limit thereof is still more preferably 500 nm.

When the photoelectric conversion layer is a composite film in which an organic semiconductor or inorganic semiconductor part and an organic-inorganic perovskite compound part are combined, the lower limit of the thickness of the composite film is preferably 30 nm and the upper limit thereof is preferably 3,000 nm. When the thickness is 30 nm or greater, the composite film can sufficiently absorb light, enhancing the photoelectric conversion efficiency. When the thickness is 3,000 nm or smaller, charges are likely to reach the electrode, enhancing the photoelectric conversion efficiency. The lower limit of the thickness is more preferably 40 nm and the upper limit thereof is more preferably 2,000 nm. The lower limit is still more preferably 50 nm and the upper limit is still more preferably 1,000 nm.

The photoelectric conversion layer may be formed by any method. It may be formed by continuously performing a vacuum evaporation method, a sputtering method, a chemical vapor deposition method (CVD), an electrochemical sedimentation method, or a printing method using a R to R device. In particular, the use of a printing method enables easy formation of a large-area solar cell that can exhibit high photoelectric conversion efficiency. Examples of the printing method include a spin coating method and a casting method.

The photoelectric conversion layer is preferably subjected to thermal annealing (heating treatment) after formation of the photoelectric conversion layer. Performing thermal annealing (heating treatment) can sufficiently increase the degree of crystallinity of the organic-inorganic perovskite compound in the photoelectric conversion layer and can further reduce a reduction in photoelectric conversion efficiency (photodegradation) due to continuous irradiation with light.

Performing such thermal annealing (heating treatment) on a solar cell including a resin film formed from a heat-resistant polymer may cause distortion in annealing due to a difference in coefficient of thermal expansion between the resin film and the photoelectric conversion layer and the like, resulting in a difficulty in achieving high photoelectric conversion efficiency. The use of the metal foil can minimize occurrence of distortion even when thermal annealing (heating treatment) is performed, leading to high photoelectric conversion efficiency.

In the case of performing the thermal annealing (heating treatment), the photoelectric conversion layer may be heated at any temperature. The temperature is preferably not lower than 100°C but lower than 250°C. When the heating temperature is not lower than 100°C, the degree of crystallinity of the organic-inorganic perovskite compound can be sufficiently increased. When the heating temperature is lower than 250°C, the heating treatment can be performed without thermal deterioration of the organic-inorganic perovskite compound. The heating temperature is more preferably not lower than 120°C and not higher than 200°C. The heating duration may also be any value, and is preferably three minutes or longer and two hours or shorter. When the heating duration is three minutes or longer, the degree of crystallinity of the organic-inorganic perovskite compound can be sufficiently increased. When the heating duration is two hours or shorter, the heating treatment can be performed without thermal deterioration of the organic-inorganic perovskite compound.

These heating operations are preferably performed in vacuum or inert gas. The dew point is preferably not higher than 10°C, more preferably not higher than 7.5°C, still more preferably not higher than 5°C.

In the step (2), the photoelectric conversion layer formed is scribed so that scribed lines along the machine direction of the substrate are provided. The details of the scribing are described later.

The method for producing a solar cell of the present invention subsequently includes a step (3) of forming an upper electrode on the photoelectric conversion layer provided with the scribed lines and scribing the upper electrode so that scribed lines along the machine direction of the substrate are provided.

The upper electrode may be either a cathode or an anode. Examples of the materials of the upper electrode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, and metals such as gold. The examples also include transparent conductive materials such as CuI, indium tin oxide (ITO), SnO₂, aluminum zinc oxide (AZO), indium zinc oxide (IZO), and gallium zinc oxide (GZO), and transparent conductive polymers. These materials may be used alone or in combination of two or more.

The upper electrode may be formed by any method. For example, it may be formed by continuously performing vapor deposition, sputtering, ion plating, or the like using a R to R device.

In the step (3), the upper electrode formed is scribed so that scribed lines along the machine direction of the substrate are provided. The detail of the scribing is described later.

In the method for producing a solar cell of the present invention, an electron transport layer may be further provided between the lower electrode or upper electrode serving as a cathode and the photoelectric conversion layer. Also, a hole transport layer may be further provided between the lower electrode or upper electrode serving as an anode and the photoelectric conversion layer. The electron transport layer and/or the hole transport layer, if provided, may be subjected to scribing together with the photoelectric conversion layer.

The electron transport layer may be formed from any material. Examples of the material include N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, (hydroxyquinolinato)aluminum, oxadiazole compounds, and benzoimidazole compounds. The examples further include naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin-film electron transport layer (buffer layer). Preferably, the electron transport layer includes a porous electron transport layer. In particular, when the photoelectric conversion layer is a composite film in which an organic semiconductor or inorganic semiconductor part and an organic-inorganic perovskite compound part are combined, the composite film is preferably formed on a porous electron transport layer. This is because a more complicated composite film (more intricate structure) can be obtained, enhancing the photoelectric conversion efficiency.

The lower limit of the thickness of the electron transport layer is preferably 1 nm and the upper limit thereof is preferably 2,000 nm. When the thickness is 1 nm or greater, holes can be sufficiently blocked. When the thickness is 2,000 nm or smaller, the layer is less likely to serve as resistance to electron transport, enhancing the photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The hole transport layer may be formed from any material. Examples of the material include P-type conductive polymers, P-type low-molecular organic semiconductors, P-type metal oxides, P-type metal sulfides, and surfactants. Specific examples thereof include compounds having a thiophene skeleton, such as poly(3-alkylthiophene). The examples also include conductive polymers having a triphenylamine skeleton, a poly-p-phenylenevinylene skeleton, a polyvinylcarbazole skeleton, a polyaniline skeleton, a polyacetylene skeleton, or the like. The examples further include compounds having a phthalocyanine skeleton, a naphthalocyanine skeleton, a pentacene skeleton, a porphyrin skeleton such as a benzoporphyrin skeleton, a spirobifluorene skeleton, or the like. The examples furthermore include molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene.

The hole transport layer may partly merge with the photoelectric conversion layer (form an intricate structure with the photoelectroc conversion layer) or be disposed in the shape of a thin film on the photoelectric conversion layer. The lower limit of the thickness of the hole transport layer in the shape of a thin film is preferably 1 nm and the upper limit thereof is preferably 2,000 nm. When the thickness is 1 nm or greater, electrons can be sufficiently blocked. When the thickness is 2,000 nm or smaller, the layer is less likely to serve as resistance to electron transport, enhancing the photoelectric conversion efficiency. The lower limit of the thickness is more preferably 3 nm and the upper limit thereof is more preferably 1,000 nm. The lower limit is still more preferably 5 nm and the upper limit is still more preferably 500 nm.

Here, scribing in the steps (1) to (3) is described.

The scribing of the lower electrode, the photoelectric conversion layer, and the upper electrode may be performed by any method. Examples of the method include mechanical scribing and laser scribing. In particular, mechanical scribing is preferred as it is comparatively inexpensive. In the mechanical scribing, a mechanical scribing device (e.g., KMPD100 available from Mitsuboshi Diamond Industrial Co., Ltd.) can be used. In the laser scribing, a laser scribing device (e.g., MPV-LD available from Mitsuboshi Diamond Industrial Co., Ltd.) can be used.

The scribing in at least one of the steps (1) to (3) includes: a step (a) of placing a laminate including the lower electrode, the photoelectric conversion layer, or the upper electrode on a stage of a scribing device and scribing the lower electrode, the photoelectric conversion layer, or the upper electrode to provide a first scribed line; a step (b) of shifting the laminate by the length of the stage of the scribing device and scribing the lower electrode, the photoelectric conversion layer, or the upper electrode to provide a second scribed line; and a step (c) of scribing the lower electrode, the photoelectric conversion layer, or the upper electrode in such a manner that the end point of the first scribed line and the start point of the second scribed line are connected to each other to provide a third scribed line.

Owing to the steps (a) to (c), the scribed lines can be surely connected even in a case where the widths of the scribed lines are narrower than conventional ones, for example, 40 µm or less. Repetition of the steps (a) to (c) can provide a long continuous scribed line along the machine direction of the substrate, resulting in reduction of the failures due to breakage of the scribed line. The steps (a) to (c) are included in the scribing of at least one of the steps (1) to (3) and may be included in the scribing of all the steps (1) to (3). In particular, the steps (a) to (c) are preferably included in the scribing of the step (1).

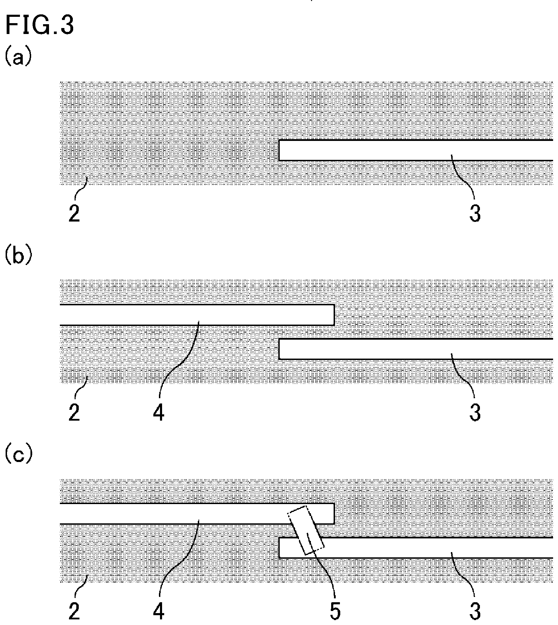

Fig. 3 shows schematic views illustrating exemplary scribing in the method for producing a solar cell of the present invention. Figs. 3(a) to 3(c) respectively show an example of the steps (a) to (c).

As shown in Fig. 3(a), in the step (a), a laminate 2 including a lower electrode, a photoelectric conversion layer, or an upper electrode is placed on a stage (not illustrated) of a scribing device and the lower electrode, the photoelectric conversion layer, or the upper electrode is scribed so that a first scribed line 3 is provided. As shown in Fig. 3(b), in the step (b), the laminate 2 is shifted by the length of the stage (not illustrated) of the scribing device by step feeding or the like and the lower electrode, the photoelectric conversion layer, or the upper electrode is scribed so that a second scribed line 4 is provided. As shown in Fig. 3(c), in the step (C), the lower electrode, the photoelectric conversion layer, or the upper electrode is scribed in such a manner that the end point of the first scribed line 3 and the start point of the second scribed line 4 are connected to each other, so that a third scribed line 5 is provided.

The stage of the scribing device is not illustrated in Fig. 3. The length of the stage of the scribing device is normally about 500 mm. Since scribing is performed on the stage of the scribing device, the lengths of the first scribed line and the second scribed line are similar to or shorter than the length of the stage of the scribing device. In Fig. 3, each of the first scribed line, the second scribed line, the third scribed line, and the continuous long scribed line formed by these scribed lines is a single line. Normally, plural scribed lines are provided with fixed intervals therebetween.

The length of the third scribed line is not limited. Yet, in consideration of the widths of the first scribed line and the second scribed line and operation accuracy of the alignment system of the scribing device (e.g., operation accuracy of about ±50 µm), the lower limit is preferably 50 µm and the upper limit is preferably 500 µm. The lower limit is more preferably 60 µm and the upper limit is more preferably 100 µm.

The shape of the third scribed line is not limited, and may be a straight line or in another shape, such as a wavy or serrated shape, as long as the end point of the first scribed line and the start point of the second scribed line can be connected to each other.

The angle of the third scribed line to the first scribed line and the second scribed line is not limited. Yet, in consideration of the widths of the first scribed line and the second scribed line and operation accuracy of the alignment system of the scribing device (e.g., operation accuracy of about ±50 µm), the lower limit is preferably 45° and the upper limit is preferably 90°. The lower limit of the angle of the third scribed line to the first scribed line and the second scribed line is more preferably 80°.

The angle of the third scribed line to the first scribed line and the second scribed line refers to a smaller angle of the angles formed between the third scribed line and the first and second scribed lines.

The length, shape, and angle of the third scribed line can be confirmed by three-dimensional image analysis using a microscope (e.g., VN-8010 available from Keyence Corporation). The length, shape, and angle of the third scribed line can be each adjusted within the range mentioned above by controlling the scribing conditions.

In the case of mechanical scribing, the scribing pressure for providing the first scribed line, the second scribed line, and the third scribed line is not limited, and may be appropriately adjusted in accordance with the type of the layer to be scribed (lower electrode, photoelectric conversion layer, or upper electrode). Specifically, for example, in the case where an air cylinder with a diameter of 3 mm is used, the scribing pressure is preferably 5 to 500 kPa, more preferably 10 to 200 kPa.

From the standpoint of reducing damage of a layer (base) under the layer to be scribed (lower electrode, photoelectric conversion layer, or upper electrode), the scribing pressure is preferably lowered at a part where the scribed lines overlap each other by controlling the scribing conditions. Specifically, for example, the scribing pressure for providing the third scribed line in the step (c) is preferably lower than the scribing pressure for providing the first scribed line and the second scribed line.

The step (c) may be conducted at any timing, and may be conducted after the step (a) or after the step (b).

In the case where the step (c) is conducted after the step (a), the scribed line obtained through the step (a) and the step (c) has a shape in which the third scribed line is connected to the end point of the first scribed line, that is, a shape in which the first scribed line is bent only at the end point. Since such an end point is easily detected by the alignment system of the scribing device, in the following step (b), detection of the end point and starting of scribing from the end point to provide the second scribed line are facilitated. In the case where the step (c) is conducted after the step (a), the step (a) and the step (c) may be conducted as a continuous series of the steps.

In the method for producing a solar cell of the present invention, step (4) may be conducted in which the upper electrode provided with the scribed line is covered with a barrier layer.

The barrier layer may be formed from any material that exhibits barrier performance. Examples of the material include thermosetting resins, thermoplastic resins, and inorganic materials. The material of the barrier layer may be a combination of the thermosetting resin or thermoplastic resin and the inorganic material.

Examples of the thermosetting resins and the thermoplastic resins include epoxy resin, acrylic resin, silicone resin, phenol resin, melamine resin, and urea resin. The examples also include butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, and polyisobutylene.

In the case where the material of the barrier layer is a thermosetting resin or a thermoplastic resin, the lower limit of the thickness of the barrier layer (resin layer) is preferably 100 nm and the upper limit thereof is preferably 100,000 nm. The lower limit of the thickness is more preferably 500 nm and the upper limit thereof is more preferably 50,000 nm. The lower limit is still more preferably 1,000 nm and the upper limit is still more preferably 20,000 nm.

Examples of the inorganic material include oxides, nitrides, and oxynitrides of Si, Al, Zn, Sn, In, Ti, Mg, Zr, Ni, Ta, W, Cu, and alloys containing two or more species thereof. In particular, in order to impart water vapor barrier performance and flexibility to the barrier layer, an oxide, a nitride, or an oxynitride of metal elements including both metal elements Zn and Sn is preferred.

In the case where the material of the barrier layer is an inorganic material, the lower limit of the thickness of the barrier layer (inorganic layer) is preferably 30 nm and the upper limit thereof is preferably 3,000 nm. When the thickness is 30 nm or greater, the inorganic layer can have sufficient vapor barrier performance, improving the moisture resistance of the solar cell. When the thickness is 3,000 nm or smaller, even in the case where the inorganic layer is thicker, the stress generated is small, suppressing detachment of the inorganic layer from the upper electrode. The lower limit of the thickness is more preferably 50 nm and the upper limit thereof is more preferably 1,000 nm. The lower limit is still more preferably 100 nm and the upper limit is still more preferably 500 nm.

Covering of the upper electrode with the thermosetting resin or the thermoplastic resin among the materials of the barrier layer may be achieved by any method. An exemplary method is to seal the upper electrode using a material of a sheet-like barrier layer. Examples thereof also include a method of applying a solution containing a material of the barrier layer dissolved in an organic solvent to the upper electrode, a method of applying a liquid monomer to be the barrier layer to the upper electrode and then crosslinking or polymerizing the liquid monomer by heat, UV, or the like, and a method of melting a material of the barrier layer by heat and then cooling the molten material.

Covering of the upper electrode using the inorganic material among the materials of the barrier layer is preferably achieved by a vacuum vapor deposition method, a sputtering method, a chemical vapor deposition (CVD) method, or an ion plating method. In particular, in order to form a dense layer, a sputtering method is preferred. A DC magnetron sputtering method is more preferred among sputtering methods.

In the sputtering method, a metal target and oxygen gas or nitrogen gas are used as starting materials, and the starting materials are deposited on the upper electrode to form a film. Thereby, an inorganic layer formed from an inorganic material can be formed.

The barrier layer may be further covered with an additional material such as a resin film or a resin film covered with an inorganic material. Thereby, water vapor can be sufficiently blocked even if a pinhole is present in the barrier layer, further improving the moisture resistance of the solar cell.

According to the method for producing a solar cell of the present invention described above, plural monolithic solar cells can be produced in batches by a roll-to-roll method. Further, a continuous long scribed line along the machine direction of a substrate can be provided so that failures due to breakage of the scribed line can be reduced. The present invention also encompasses a solar cell produced by the method for producing a solar cell of the present invention.

### - Advantageous Effects of Invention

The present invention can provide a method for producing a solar cell, the method being for producing plural monolithic solar cells in batches by a roll-to-roll method, in which a continuous long scribed line along the machine direction of a substrate is provided so that failures due to breakage of the scribed line are reduced. The present invention can also provide a solar cell obtained by the method for producing a solar cell.

### BRIEF DESCRIPTION OF DRAWINGS

Fig. 1 is a top view schematically illustrating an exemplary method for providing scribed lines along the machine dirction of a substrate by a roll-to-roll method.
Fig. 2 shows top views schematically illustrating exemplary connecting portions of scribed lines when the scribed lines are provided along the machine direction of a substrate by a roll-to-roll method.
Fig. 3 shows top views schematically illustrating exemplary scribing in the method for producing a solar cell of the present invention.
Fig. 4 is a schematic view of an exemplary crystal structure of an organic-inorganic perovskite compound.

### DESCRIPTION OF EMBODIMENTS

Embodiments of the present invention are more specifically described with reference to, but not limited to, the following examples.

### (Example 1)

### (1) Production of a solar cell

### (Step 1)

An aluminum foil (available from UACJ Corp., multipurpose aluminum material A1N30 grade, thickness: 100 pm) was subjected to sulfuric acid anodizing for a treatment duration of 30 minutes, so that an aluminum oxide film (thickness: 5 µm, proportion of thickness: 5%) was formed on a surface of the aluminum foil. Thereby, a substrate was obtained.

An Al film having a thickness of 100 nm was formed on an aluminum oxide film using a vapor deposition device while the substrate was shifted using a R to R device (SUPLaDUO available from Chugai Ro Co., Ltd.), and then a Ti film having a thickness of 100 nm was formed on the Al film by a vapor deposition method. Further, a TiO₂ film was formed on the Ti film by a sputtering method. Thereby, a cathode was prepared.

A sample on which the cathode had been formed was placed on a stage of a mechanical scribing device (KMPD100 available from Mitsuboshi Diamond Industrial Co., Ltd.), and the cathode was scribed by mechanical patterning at a scribing pressure of 100 kPa. Thereby, a first scribed line was provided. The sample on which the cathode had been formed was shifted by the length of the stage of the mechanical scribing device, and the cathode was scribed by mechanical patterning at a scribing pressure of 100 kPa. Thereby, a second scribed line was provided. Further, the cathode was scribed by mechanical patterning at a scribing pressure of 90 kPa in such a manner that the end point of the first scribed line and the start point of the second scribed line were connected to each other. Thereby, a third scribed line (length: 100 µm, shape: straight line, angle: 90°) was provided. By repeating the above process, a continuous long scribed line was provided along the machine direction of the substrate.

The length, shape, and angle of the third scribed line were obtained by three-dimensional image analysis using a microscope (VN-8010 available from Keyence Corporation).

### (Step 2)

A titanium oxide paste containing polyisobutyl methacrylate as an organic binder and titanium oxide (mixture of those with an average particle size of 10 nm and those with an average particle size of 30 nm) was applied to the cathode by a spin coating method, while the sample on which the cathode had been formed was shifted using a R to R device (TM-MC available from Hirano Tecseed Co., Ltd.). Then, the sample was fired at 200°C for 30 minutes. Thereby, a porous electron transport layer with a thickness of 500 nm was formed.

Subsequently, lead iodide as a metal halide compound was dissolved in N,N-dimethylformamide (DMF) to prepare a 1 M solution. The resulting solution was applied to the porous electron transport layer by a spin coating method to form a film, while the sample on which the porous electron transport layer had been formed was shifted using the R to R device (TM-MC available from Hirano Tecseed Co., Ltd.). Separately, methylammonium iodide as an amine compound was dissolved in 2-propanol to prepare a 1 M solution. The sample with the above lead iodide film was immersed into this solution to form a layer containing CH₃NH₃PbI₃ which is an organic-inorganic perovskite compound. Thereafter, the obtained sample was subjected to annealing treatment at 120°C for 30 minutes.

Next, 68 mM of Spiro-OMeTAD (having a spirobifluorene skeleton), 55 mM of t-butyl pyridine, and 9 mM of a bis(trifluoromethylsulfonyl)imide silver salt were dissolved in 25 µL of chlorobenzene to prepare a solution. This solution was applied to the photoelectric conversion layer by a spin coating method, while the sample on which the photoelectric conversion layer had been formed was shifted using the R to R device (TM-MC available from Hirano Tecseed Co., Ltd.). Thereby, a hole transport layer having a thickness of 150 nm was formed.

Subsequently, the layer that is a combination of the electron transport layer, the photoelectric conversion layer, and the hole transport layer was patterned using a laser scribing device (MPV-LD available from Mitsuboshi Diamond Industrial Co., Ltd.).

### (Step 3)

An ITO film having a thickness of 100 nm was formed as an anode (transparent electrode) on the hole transport layer by a vapor deposition method, while the sample on which the hole transport layer had been formed was shifted using the R to R device (SUPLaDUO available from Chugai Ro Co., Ltd.). The ITO film was patterned using a mechanical scribing device.

### (Step 4)

A barrier layer formed from ZnSnO having a thickness of 100 nm was formed on the anode by a sputtering method, while the sample on which the anode had been formed was shifted using a R to R device (RTC-S400 available from Toray Engineering Co., Ltd.). Then, the sample on which the barrier layer had been formed was cut to be divided to individual solar cells.

### (2) Observation of scribed lines

The scribed lines provided on the cathode were observed by three-dimensional image analysis using a microscope (VN-8010 available from Keyence Corporation). Specifically, the overlap length of the third scribed line with the first scribed line and the overlap length of the third scribed line with the second scribed line were observed.

The cases where the third scribed line completely overlapped the first and second scribed lines were evaluated as "o" (Good). The cases where the third scribed line partly overlapped the first and second scribed line were evaluated as "Δ" (Acceptable). The cases where the third scribed line did not overlap the first and second scribed lines and the first scribed line was not connected to the second scribed line were evaluated as "×" (Poor).

### (Examples 2 to 11, Comparative Examples 1 to 3)

Solar cells were obtained as in Example 1, except that the scribing pressure was changed as shown in Table 1, that the length, shape, angle, and like properties of the third scribed line were changed by controlling the scribing conditions, and the timing when the step (c) was conducted was changed as shown in Table 1.

### <Evaluation>

The solar cells obtained in the examples and comparative examples were evaluated as follows. Table 1 shows the results.

### (Measurement of photoelectric conversion efficiency)

A power source (model 236, available from Keithley Instruments Inc.) was connected between the electrodes of the solar cell. The photoelectric conversion efficiency was measured in an exposure area of 1 cm² using a solar simulator (available from Yamashita Denso Corp.) at an intensity of 100 mW/cm².

The photoelectric conversion efficiency values of the solar cells obtained in the examples and comparative examples were standardized with the photoelectric conversion efficiency of the solar cell obtained in Example 1 taken as 1.0. The cases where the standardized value was not less than 0.9 were evaluated as "○○" (Excellent). The cases where the standardized value was less than 0.9 but not less than 0.7 were evaluated as "o" (Good). The cases where the standardized value was less than 0.7 but not less than 0.6 were evaluated as "Δ" (Acceptable). The cases where the standardized value was less than 0.6 were evaluated as "×" (Poor).

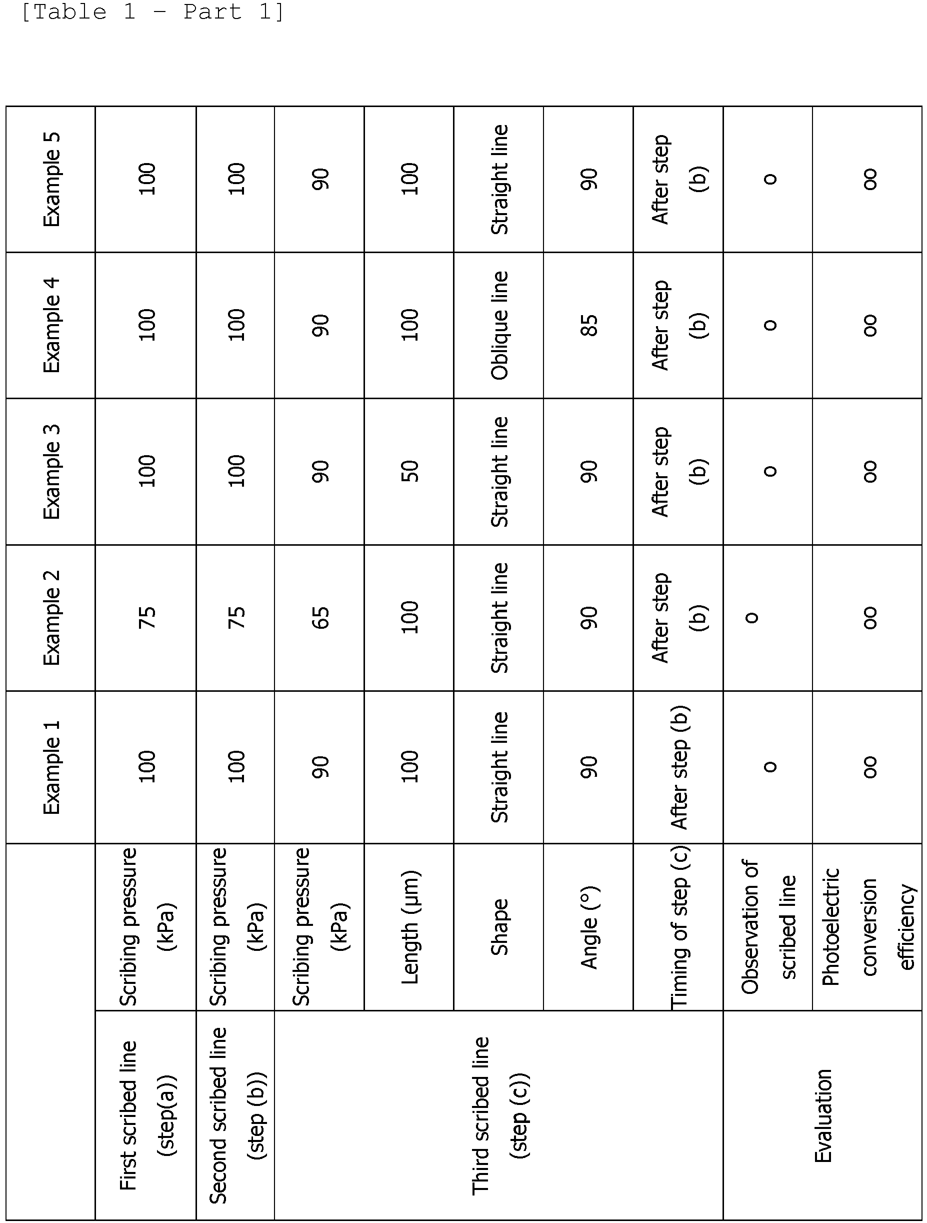

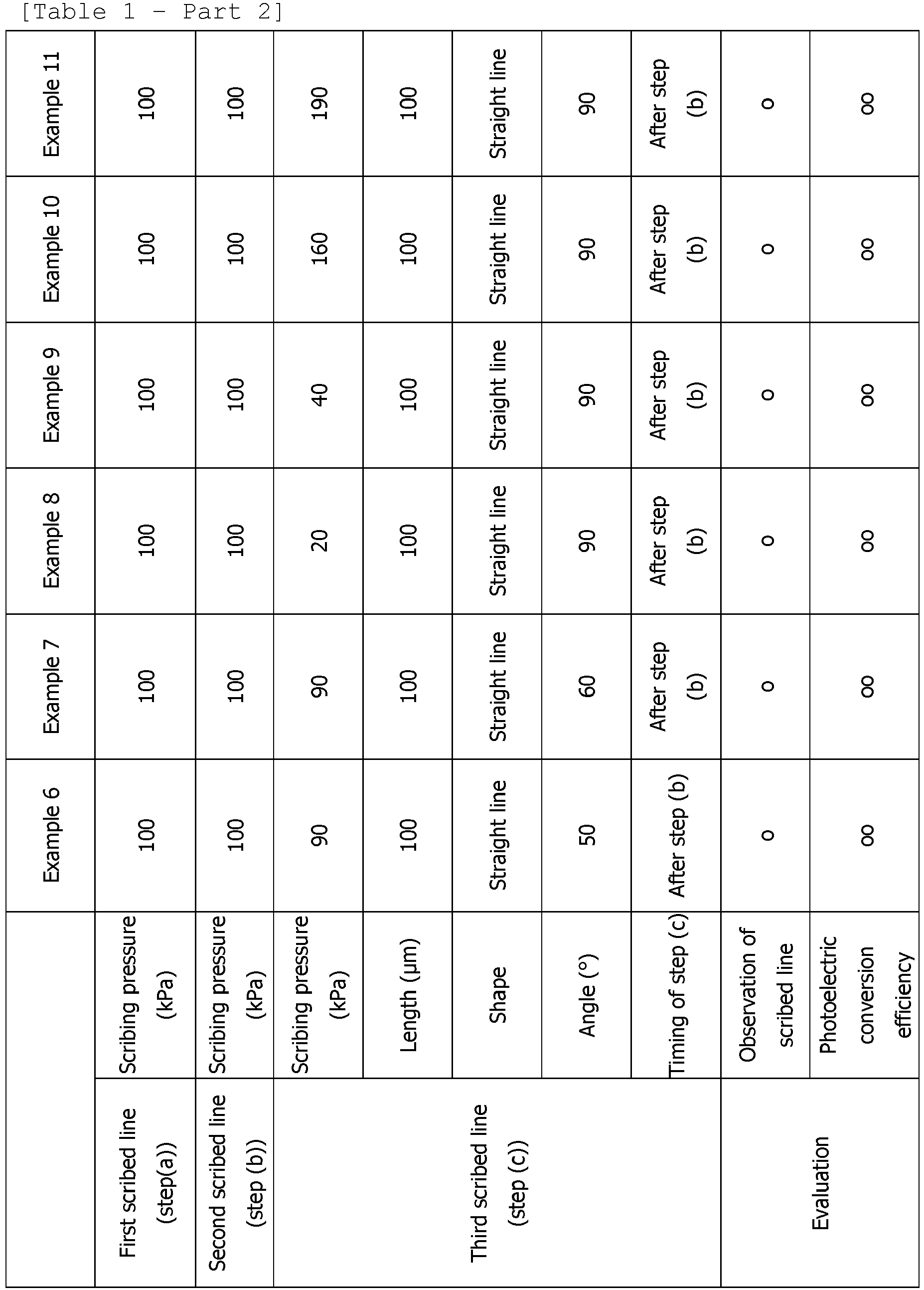

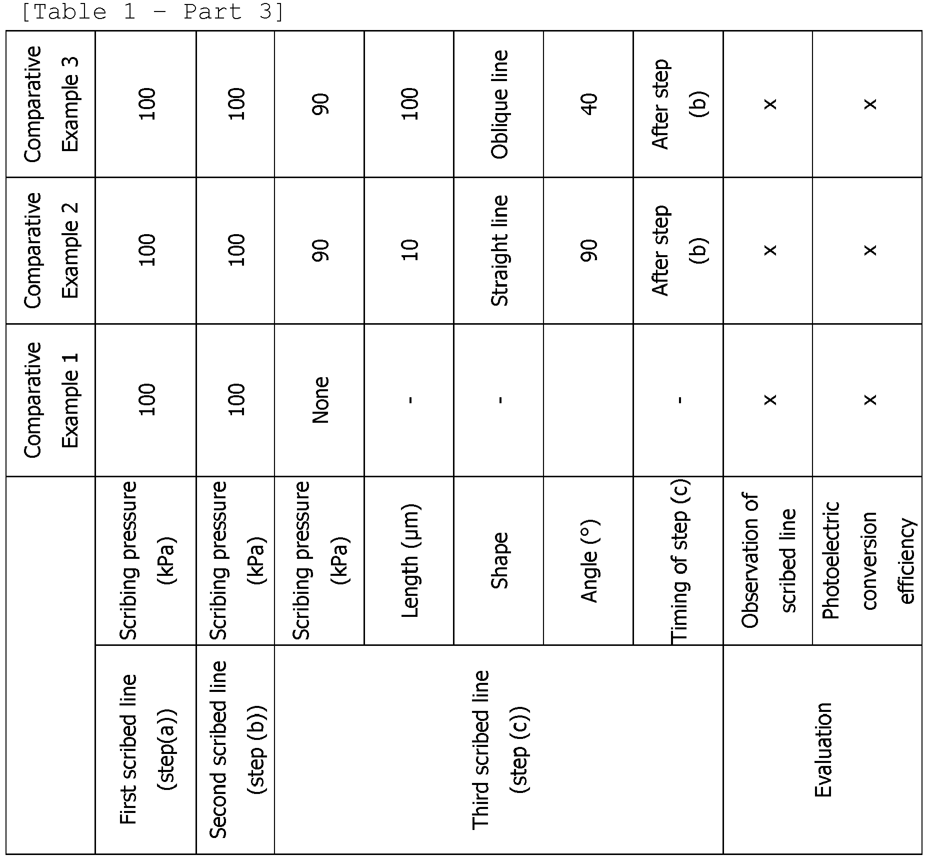

### INDUSTRIAL APPLICABILITY

The present invention can provide a method for producing a solar cell, the method being for producing plural monolithic solar cells in batches by a roll-to-roll method, in which a continuous long scribed line is provided along the machine direction of a substrate so that failures due to breakage of the scribed line are reduced. The present invention can also provide a solar cell obtained by the method for producing a solar cell.

### REFERENCE SIGNS LIST

1 stage of scribing device
2 laminate
3 first scribed line
4 second scribed line
5 third scribed line
A connecting portion between first scribed line and second scribed line

## Claims

1. A method for producing a solar cell,
the method being for producing plural monolithic solar cells in batches by a roll-to-roll method, the method comprising:
a step (1) of forming a lower electrode on a long substrate and scribing the lower electrode to provide a scribed line along the machine direction of the substrate;
a step (2) of forming a photoelectric conversion layer on the lower electrode provided with the scribed line and scribing the photoelectric conversion layer to provide a scribed line along the machine direction of the substrate; and
a step (3) of forming an upper electrode on the photoelectric conversion layer provided with the scribed line and scribing the upper electrode to provide a scribed line along the machine direction of the substrate,
the scribing in at least one of the steps (1) to (3) including:
a step (a) of placing a laminate including the lower electrode, the photoelectric conversion layer, or the upper electrode on a stage of a scribing device and scribing the lower electrode, the photoelectric conversion layer, or the upper electrode to provide a first scribed line;
a step (b) of shifting the laminate by the length of the stage of the scribing device and scribing the lower electrode, the photoelectric conversion layer, or the upper electrode to provide a second scribed line; and
a step (c) of scribing the lower electrode, the photoelectric conversion layer, or the upper electrode in such a manner that the end point of the first scribed line and the start point of the second scribed line are connected to each other to provide a third scribed line.

2. The method for producing a solar cell according to claim 1,
wherein the scribing pressure for providing the third scribed line in the step (c) is set lower than the scribing pressure for providing the first scribed line and the second scribed line.

3. The method for producing a solar cell according to claim 1 or 2,
wherein the step (c) is conducted after the step (a), and the step (a) and the step (c) are a continuous series of steps.

4. The method for producing a solar cell according to claim 1, 2, or 3,
wherein the photoelectric conversion layer contains an organic-inorganic perovskite compound represented by the formula R-M-X₃, wherein R represents an organic molecule; M represents a metal atom; and X represents a halogen atom or a chalcogen atom.

5. A solar cell obtained by the method for producing a solar cell according to claim 1, 2, 3, or 4.
